# FASCICULE DE BREVET EUROPEEN

(11) **EP 2 145 517 B1**
(45) Date de publication et mention de la délivrance du brevet: **24.10.2018**
(21) Numéro de dépôt: 08805554.6
(22) Date de dépôt: 07.05.2008
(51) Int. Cl.: H05K 9/00

(54) **GAINE DE PROTECTION ÉLECTROMAGNÉTIQUE EN TEXTILE**
AUS EINEM TEXTILSTOFF HERGESTELLTE ELEKTROMAGNETISCHE SCHUTZHÜLLE
ELECTROMAGNETIC PROTECTION SHEATH MADE OF TEXTILE

(30) Priorité: 07.05.2007 FR 0754917
(43) Date de publication de la demande: 20.01.2010
(73) Titulaire: Federal Mogul Systems Protection, 60800 Crépy-en-Valois (FR)
(72) Inventeur: ABDELMOULA, Rafik, F-60180 Nogent sur Oise (FR); THOMAS, Patrick, F-60800 Crepy en Valois (FR); DELLA PUTTA, Lucia, F-60280 Venette (FR); RODRIGUES, Thierry, F-95440 Ecouen (FR); SIMOENS, Amélie, F-60200 Compiegne (FR)
(74) Mandataire: Santarelli
(86) Numéro de dépôt international: PCT/FR2008/000649
(87) Numéro de publication internationale: WO 2008/152243

(56) Documents cités:
- EP-A2- 0 153 823
- DE-U1- 9 112 362
- US-A- 4 791 236
- US-A- 4 946 722
- US-A1- 2002 195 260

## Description

La présente invention concerne une gaine de protection électromagnétique en textile.

De manière générale, elle concerne la protection de conducteurs électriques ou autres des interférences électromagnétiques (en anglais Electromagnetic Interference ou EMI) au moyen d'une gaine présentant des propriétés de blindage.

Une gaine textile est proposée dans le document US 4 684 762.

Cette gaine est constituée d'un textile tissé ou tressé à partir de filaments dans lesquels seulement une portion des fibres est conductrice.

Ainsi, on connaît une gaine en textile comprenant des fils de chaine formés de filaments comprenant au moins 20% à 80% en poids de fibres conductrices et des fils de trame formés de filaments comprenant une proportion comprise entre 1% et 20% en poids de fibres conductrices.

Une telle gaine présente ainsi des filaments conducteurs aussi bien dans le sens longitudinal que transversal, permettant ainsi de réaliser des connexions électriques au niveau des croisements des filaments dans la structure textile de blindage électromagnétique.

Toutefois, ces gaines comportant une forte proportion de métal conducteur, restent relativement lourdes, ce qui est particulièrement gênant dans les applications aéronautiques.

La présente invention a pour but de résoudre les inconvénients précités et de proposer une structure de gaine de protection électromagnétique légère.

A cet effet, la présente invention vise une gaine de protection électromagnétique en textile, dans laquelle le textile est formé de filaments conducteurs s'étendant suivant une première direction et de filaments non conducteurs entrelacés avec les filaments conducteurs, les filaments conducteurs étant constitués de tresse comprenant des fils de cuivre.

La Demanderesse a en effet constaté qu'il était possible d'obtenir une gaine de protection électromagnétique efficace sans croisement de filaments conducteurs dans la structure textile.

Ainsi, les filaments conducteurs de la structure ne sont pas liés électriquement entre eux par le biais de filaments entrelacés.

Cette structure de textile comportant uniquement des filaments conducteurs dans une direction permet d'alléger la gaine et, en outre, de rendre son montage plus facile grâce à la souplesse du textile utilisé.

Selon une caractéristique préférée de l'invention, la première direction correspond à une direction longitudinale de la gaine.

Ainsi, les filaments conducteurs s'étendent dans la direction longitudinale de la gaine de manière à assurer une bonne protection électromagnétique des câbles recouverts par la gaine.

De manière avantageuse, les filaments non conducteurs comprennent au moins un fil thermoformable.

Grâce à la présence d'un fil thermoformable, il est possible d'obtenir une gaine de protection auto-fermable par traitement thermique du textile.

Ainsi, la gaine peut être réalisée à partir d'un textile à plat, lui-même thermoformé pour obtenir une gaine tubulaire.

Dans un mode de réalisation pratique de l'invention, le textile est un tissé, les filaments conducteurs constituant des fils de chaîne et les filaments non conducteurs constituant des fils de trame.

Dans un autre mode de réalisation, le textile est une tresse, les filaments conducteurs s'étendant dans une direction longitudinale du textile, et les filaments non conducteurs étant tressés selon des directions sécantes à la direction longitudinale du textile.

Selon une autre caractéristique avantageuse de l'invention, les filaments non conducteurs ont un diamètre supérieur au diamètre des filaments conducteurs, de telle sorte qu'ils permettent de protéger mécaniquement les filaments conducteurs.

Ainsi, les propriétés de blindage de la gaine ne sont pas détériorées, même en cas d'usure par frottement de cette gaine, ces frottements étant limités aux filaments non conducteurs de diamètre plus important.

D'autres particularités et avantages de l'invention apparaîtront encore dans la description ci-après.

Aux dessins annexés, donnés à titre d'exemples non limitatifs :
- la figure 1 est une vue en perspective schématique d'une gaine de protection électromagnétique conforme à un mode de réalisation de l'invention ;
- la figure 2 est un schéma illustrant un textile d'une gaine de protection électromagnétique conforme à un premier mode de réalisation de l'invention ;
- la figure 3 est un schéma illustrant un textile d'une gaine de protection électromagnétique conforme à un second mode de réalisation de l'invention ; et
- la figure 4 est une vue analogue à la figure 1 illustrant un autre mode de réalisation de l'invention.

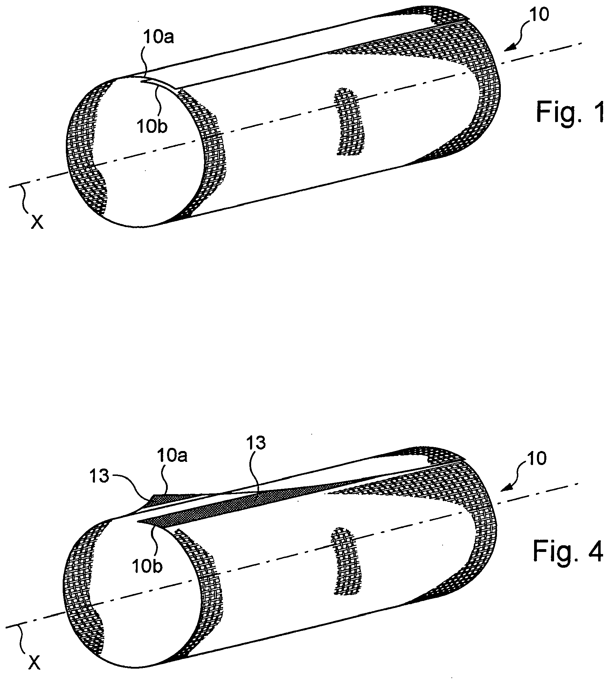

Une gaine de protection électromagnétique en textile conforme à un mode de réalisation de l'invention est illustrée à la figure 1.

Dans ce mode de réalisation de l'invention, la gaine de protection est réalisée à partir d'un textile formé à plat qui est ensuite transformé en gaine tubulaire grâce à un procédé de thermoformage.

On obtient ainsi une gaine de protection électromagnétique tubulaire fendue longitudinalement et auto-fermable 10, dont les bords longitudinaux 10a, 10b présentent une portion de recouvrement plus ou moins importante suivant le diamètre du faisceau de câbles sur lequel cette gaine de protection électromagnétique 10 est montée.

Cette structure auto-fermable de la gaine permet de faciliter le montage et la maintenance de cette gaine autour d'un faisceau de câbles, même lorsque celui-ci est connecté à ses extrémités.

Il suffit en effet d'écarter les bords longitudinaux 10a, 10b pour permettre le passage de la gaine autour d'un faisceau de câbles.

Elle permet de rajouter des câbles au faisceau et de visualiser les câbles lors des opérations de maintenance.

Cette gaine 10 est ensuite fermée automatiquement par mémoire de forme des bords 10a, 10b l'un contre l'autre.

Le textile utilisé pour réaliser cette gaine de protection conforme à l'invention peut être de différentes natures, et par exemple réalisé à partir d'un procédé de tissage, tressage ou tricotage.

De manière générale, ce textile est formé à partir de filaments de deux types :
- d'une part, des filaments conducteurs qui s'étendent suivant une première direction, et par exemple dans l'exemple de réalisation illustré à la figure 1 selon la direction longitudinale X de la gaine 10 ; et
- d'autre part, des filaments non conducteurs entrelacés avec les filaments conducteurs.

Ces filaments non conducteurs entrelacés avec les filaments conducteurs s'étendent ainsi selon des directions sécantes (perpendiculaire ou non) aux filaments conducteurs qui s'étendent dans la direction longitudinale X de la gaine.

Dans ce mode de réalisation, afin d'assurer le caractère auto-fermable de la gaine, ces filaments non conducteurs comprennent au moins un fil thermoformable.

Plus généralement, les filaments conducteurs peuvent être constitués de fil(s) ou de fibres.

Tout type d'assemblage de fils ou fibres peut être utilisé, et notamment sous forme de tresse ou de bande tressée, tissée ou non tissée.

Les fils ou fibres conducteurs peuvent être métalliques ou métallisées.

Les assemblages de fils ou fibres peuvent ainsi comporter des fils ou fibres métallique, des fils ou fibres métallisées ou encore un mélange de fils ou fibres métalliques et métallisées.

Les assemblages de fils ou fibres comprennent au moins une portion de fils ou fibres conductrices.

Les filaments conducteurs peuvent être ainsi constitués uniquement de fils ou fibres conducteurs ou comporter seulement une portion de fils ou fibres non conducteurs.

A titre d'exemple, les fils ou fibres conducteurs métallique peuvent être réalisés en cuivre ou en tout autre matériau métallique conducteur.

Les fils ou fibres conducteurs peuvent également être réalisés à partir de fils non conducteurs métallisés, c'est-à-dire revêtus d'un revêtement conducteur, par exemple en cuivre ou argent.

A titre d'exemple, un polymère métallisé commercialisé sous la référence Aracon® par du Pont de Nemours peut être utilisé.

Les fils ou fibres conducteurs peuvent également être réalisées à partir de matière polymère ou élastomère chargée par des particules ou fibres de matériau conducteur.

On peut utiliser à titre d'exemple un matériau du type X-static® de Nobbelfiber.

De même, les filaments non conducteurs peuvent être constitués de fil ou fibre, ou encore d'un assemblage, et par exemple une tresse ou une bande tressée, tissée ou non tissée, de fils ou de fibres non conducteurs.

Ces fils ou fibres non conducteurs sont constitués par exemple de fibres minérales ou synthétiques, ou encore d'un mélange de fibres minérales et synthétiques.

A titre d'exemple, les fibres minérales peuvent être constituées de fibres de verre.

Les fibres synthétiques non conductrices peuvent être formées en polyester, en PPS (Polyphénylènesulfide), en PEEK (acronyme de Polyetheretherkétone correspondant au polyétheréthercétone), en polyamide, en polyéthylène, en polypropylène, en PEI (polyéthylèneimine), en PEK (acronyme de Polyetherketone correspondant au polyéthercétone) ou en PEKK (acronyme de Polyetherketoneketone correspondant au polyéthercétonecétone).

Ces fibres présentent l'avantage d'être thermoformables.

Par ailleurs, il est également possible d'utiliser des fibres en Méta-aramide du type Nomex® ou en PTFE (Polytetrafluoroéthylène) du type Téflon® commercialisés par la société du Pont de Nemours.

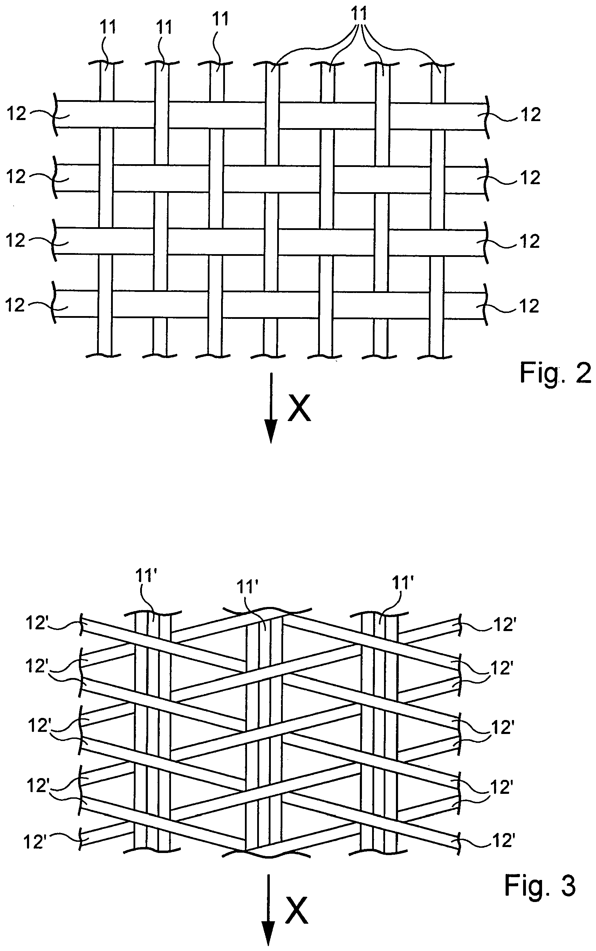

Comme illustré à la figure 2, un exemple de textile est réalisé par tissage.

Les filaments conducteurs 11 constituent des fils de chaine du tissu et s'étendent suivant une direction longitudinale X.

Les filaments non conducteurs 12 constituent des fils de trame du tissu et s'étendent ainsi dans une direction transversale et sensiblement perpendiculaire à la direction longitudinale X.

Dans cet exemple, les filaments conducteurs 11 peuvent être par exemple réalisés à partir de tresses en fils de cuivre et les filaments non conducteurs peuvent être constitués d'un monofilament en PPS thermoformable.

De préférence, les filaments non conducteurs 12 ont un diamètre supérieur au diamètre des filaments conducteurs 11.

Ainsi, l'usure par frottement ou abrasion de la gaine peut être limitée aux filaments non conducteurs 12.

Les propriétés de blindage de la gaine peuvent ainsi être préservées même en cas d'usure par frottement de cette gaine.

Un second mode de réalisation d'un textile est illustré à la figure 3.

Le textile est réalisé par tressage.

Les filaments conducteurs 11' s'étendent suivant une direction longitudinale X du textile en forme de tresse.

Les filaments non conducteurs 12' sont tressés selon des directions sécantes à la direction longitudinale X du textile.

Ils sont ainsi tressés autour des filaments conducteurs 11' et permettent de réaliser la structure entrelacée du textile.

Dans ce mode de réalisation, et de manière nullement limitative, les filaments conducteurs 11' sont constitués de tresses en fils de cuivre.

Les filaments non conducteurs 12' sont constitués d'un fil en PPS thermoformable.

Bien entendu, d'autres types de matériaux ou de filaments conducteurs et non conducteurs peuvent être utilisés.

On notera que dans les deux modes de réalisation illustrés ci-dessus, la structure textile ne présente pas, au niveau des croisements des filaments, de croisement de filaments conducteurs.

Toutefois, la protection électromagnétique reste efficace dès lors que les filaments conducteurs s'étendent parallèlement les uns aux autres suivant une première direction, et dans ce mode de réalisation, dans la direction longitudinale de la gaine.

Grâce à l'utilisation de filaments non conducteurs dans les autres directions de la gaine, il est possible de limiter le poids de la gaine et de lui conférer une souplesse satisfaisante.

Ce type de gaine de protection électromagnétique, relativement légère est particulièrement bien adapté aux applications aéronautiques, pour la protection des faisceaux de câbles dans les avions.

Grâce à l'utilisation d'un fil thermoformable, la structure textile peut être réalisée à plat, par tissage ou tressage, puis soumise à un traitement à la chaleur, à une température de plus de 200° C pour obtenir la déformation du fil thermoformable dans la direction sensiblement transversale de la gaine, qui devient ainsi auto-fermable.

Bien entendu, la gaine 10 peut ne pas être autofermable mais comporter des moyens de fermeture au niveau de ses bords longitudinaux 10a, 10b.

Comme illustré à la figure 4, des moyens de fermeture autoagrippante 13 du type bande Velcro® peuvent être prévus sur une face intérieure d'un bord longitudinal 10a et une face extérieure d'un bord longitudinal 10b de la gaine 10 pour la fermeture de la gaine autour d'un faisceau de câbles.

La gaine 10 peut également avoir des propriétés d'autofermabilité grâce à un traitement différent du thermoformage.

Par exemple, un traitement de pressage à froid de la gaine tissée à plat et repliée en deux peut permettre de procurer à cette gaine un assemblage ayant une mémoire de forme.

Une telle gaine peut ainsi, après mise en place autour d'un faisceau de câbles, retrouver sa forme fermée pour recouvrir le faisceau de câbles.

Bien entendu, la présente invention n'est pas limitée aux exemples de réalisation décrits ci-dessus.

En particulier, la gaine de protection électromagnétique pourrait également être réalisée par tricotage.

De même, la gaine de protection électromagnétique pourrait être réalisée sous forme d'une gaine tubulaire fermée directement par une technique de tissage, tressage ou tricotage adaptée.

## Revendications

1. Gaine de protection électromagnétique en textile, **caractérisée en ce que** le textile est formé de filaments conducteurs (11, 11') s'étendant suivant une première direction correspondant à une direction longitudinale (X) de la gaine (10) de manière à assurer une protection électromagnétique et de filaments non conducteurs (12, 12') entrelacés avec lesdits filaments conducteurs (11, 11'), les filaments non conducteurs (12, 12') ayant un diamètre supérieur au diamètre des filaments conducteurs (11, 11') de sorte à protéger les filaments conducteurs d'une usure par frottement ou abrasion.

2. Gaine de protection électromagnétique conforme à la revendication 1, **caractérisée en ce que** lesdits filaments non conducteurs (12, 12') comprennent au moins un fil thermoformable.

3. Gaine de protection électromagnétique conforme à la revendication 1 ou la revendication 2, **caractérisée en ce qu'**elle est constituée d'une gaine fendue longitudinalement auto-fermable.

4. Gaine de protection électromagnétique conforme à la revendication 1, **caractérisée en ce qu'**elle est constituée d'une gaine fendue longitudinalement comportant des moyens de fermeture autoagrippante (13) au niveau des bords longitudinaux (10a, 10b) de ladite gaine (10).

5. Gaine de protection électromagnétique conforme à la revendication 1, **caractérisée en ce qu'**elle est constituée d'une gaine fendue longitudinalement ayant une mémoire de forme.

6. Gaine de protection électromagnétique conforme à la revendication 1, **caractérisée en ce qu'**elle est constituée d'une gaine tubulaire fermée.

7. Gaine de protection électromagnétique conforme à l'une des revendications 1 à 6, **caractérisée en ce que** le textile est un tissé, lesdits filaments conducteurs (11) constituant des fils de chaîne et lesdits filaments non conducteurs (12) constituant des fils de trame.

8. Gaine de protection électromagnétique conforme à l'une des revendications 1 à 6, **caractérisée en ce que** le textile est une tresse, les filaments conducteurs (11') s'étendant dans une direction longitudinale (X) du textile, et les filaments non conducteurs (12') étant tressés selon des directions sécantes à ladite direction longitudinale (X) du textile.

9. Gaine de protection électromagnétique conforme à l'une des revendications 1 à 8, **caractérisée en ce que** les filaments non conducteurs (12, 12') sont constitués d'un fil en PPS.

## Patentansprüche

1. Elektromagnetische Schutzhülle aus Textilstoff, **dadurch gekennzeichnet, dass** der Textilstoff aus leitenden Fäden (11, 11'), die sich entlang einer ersten Richtung erstrecken, die einer Längsrichtung (X) der Hülle (10) entspricht, um einen elektromagnetischen Schutz sicherzustellen, und nicht leitenden Fäden (12, 12') gebildet ist, die mit den leitenden Fäden (11, 11') verflochten sind, wobei die nicht leitenden Fäden (12, 12') einen Durchmesser haben, der größer ist als der Durchmesser der leitenden Fäden (11, 11'), um die leitenden Fäden vor einem Verschleiß durch Reibung oder Abrieb zu schützen.

2. Elektromagnetische Schutzhülle nach Anspruch 1, **dadurch gekennzeichnet, dass** die nicht leitenden Fäden (12, 12') mindestens einen wärmeformbaren Faden umfassen.

3. Elektromagnetische Schutzhülle nach Anspruch 1 oder Anspruch 2, **dadurch gekennzeichnet, dass** sie aus einer längs geschlitzten, selbstschließenden Hülle besteht.

4. Elektromagnetische Schutzhülle nach Anspruch 1, **dadurch gekennzeichnet, dass** sie aus einer längs geschlitzten Hülle besteht, die Klettverschlusseinrichtungen (13) im Bereich der Längsränder (10a, 10b) der Hülle (10) umfasst.

5. Elektromagnetische Schutzhülle nach Anspruch 1, **dadurch gekennzeichnet, dass** sie aus einer längs geschlitzten Hülle mit einem Formgedächtnis besteht.

6. Elektromagnetische Schutzhülle nach Anspruch 1, **dadurch gekennzeichnet, dass** sie aus einer geschlossenen rohrförmigen Hülle besteht.

7. Elektromagnetische Schutzhülle nach einem der Ansprüche 1 bis 6, **dadurch gekennzeichnet, dass** der Textilstoff ein Gewebe ist, wobei die leitenden Fäden (11, 11') die Kettfäden und die nicht leitenden Fäden (12, 12') die Schussfäden bilden.

8. Elektromagnetische Schutzhülle nach einem der Ansprüche 1 bis 6, **dadurch gekennzeichnet, dass** der Textilstoff ein Geflecht ist, wobei sich die leitenden Fäden (11') in einer Längsrichtung (X) des Textilstoffs erstrecken und die nicht leitenden Fäden (12') in Richtungen eingeflochten sind, welche die Längsrichtung (X) des Textilstoffs schneiden.

9. Elektromagnetische Schutzhülle nach einem der Ansprüche 1 bis 8, **dadurch gekennzeichnet, dass** die nicht leitenden Fäden (12, 12') aus einem Faden aus PPS bestehen.

## Claims

1. Textile electromagnetic protection sheath, **characterized in that** the textile is formed of conductive filaments (11, 11') extending in a first direction (X)corresponding to a first longitudinal direction (X) of the sheath (10) in order to provide electromagnetic protection and non-conductive filaments (12, 12') interlaced with said conductive filaments (11, 11'), the non-conductive filaments (12, 12') having a diameter greater than the diameter of the conductive filaments (11, 11') in order to protect the conductive filaments from wear by rubbing or abrasion.

2. Electromagnetic protection sheath according to claim 1, **characterized in that** said non-conductive filaments (12, 12') include at least one thermoformable thread.

3. Electromagnetic protection sheath according to claim 1 or claim 2, **characterized in that** it consists of a self-closing longitudinally slit sheath.

4. Electromagnetic protection sheath according to claim 1, **characterized in that** it consists of a longitudinally slit sheath including self-gripping closure means (13) on the longitudinal edges (10a, 10b) of said sheath (10).

5. Electromagnetic protection sheath according to claim 1, **characterized in that** it consists of a longitudinally slit sheath having a shape memory.

6. Electromagnetic protection sheath according to claim 1, **characterized in that** it is a closed tubular sheath.

7. Electromagnetic protection sheath according to any of claims 1 to 6, **characterized in that** the textile is woven, said conductive filaments (11) constituting warp threads and said non-conductive filaments (12) constituting weft threads.

8. Electromagnetic protection sheath according to any of claims 1 to 6, **characterized in that** the textile is a braid, the conductive filaments (11') extending in a longitudinal direction (X) of the textile and the non-conductive filaments (12') being braided in directions intersecting said longitudinal direction (X) of the textile.

9. Electromagnetic protection sheath according to any of claims 1 to 8, **characterized in that** the non-conductive filaments (12, 12') consist of a PPS thread.
